(19) Europäisches Patentamt / European Patent Office / Office européen des brevets

(11) **EP 1 742 350 A2**

(12) **EUROPÄISCHE PATENTANMELDUNG**

(43) Veröffentlichungstag:
**10.01.2007 Patentblatt 2007/02**

(51) Int Cl.:
***H03B 5/36*** *(2006.01)*

(21) Anmeldenummer: **06013553.0**

(22) Anmeldetag: **30.06.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **08.07.2005 DE 102005032468**

(71) Anmelder: **ATMEL Germany GmbH**
**74072 Heilbronn (DE)**

(72) Erfinder: **Karthaus, Udo, Dr.**
**89079 Ulm (DE)**

Bemerkungen:
Amended claims in accordance with Rule 86 (2) EPC.

(54) **Integrierte Quarzoszillatorschaltung**

(57) Vorgestellt wird eine Integrierte Quarzoszillatorschaltung (22; 44) mit einem kapazitiven Spannungsteiler (18), der eine erste Kapazität (C1) und eine zweite Kapazität (C2) aufweist, sowie mit einem ersten Transkonduktanzverstärker (24; 46), der in einer Schleife angeordnet ist, die einen ersten Anschluss (26) und einen zweiten Anschluss (28) der ersten Kapazität (C1) verbindet. Die Quarzoszillatorschaltung (22; 44) zeichnet sich dadurch aus, dass ein Eingang (30; 46_E_+) des ersten Transkonduktanzverstärkers (24; 46) an einen Mittelabgriff zwischen der ersten Kapazität (C1) und der zweiten Kapazität (C2) angeschlossen ist, ein Ausgang (32; 46_A-) des ersten Transkonduktanzverstärkers (24; 46) an den ersten Anschluss (26) der ersten Kapazität (C 1) angeschlossen ist, und die Quarzoszillatorschaltung (22) ein an den Mittelabgriff parallel zu der zweiten Kapazität (C2) angeschlossenes leitfähiges Element (34; 48) aufweist.

FIG.3

**Beschreibung**

Die Erfindung betrifft eine Integrierte Quarzoszillatorschaltung mit einem kapazitiven Spannungsteiler, der eine erste Kapazität und eine zweite Kapazität aufweist, sowie mit einem ersten Transkonduktanzverstärker, der in einer Schleife angeordnet ist, die einen ersten Anschluss und einen zweiten Anschluss der ersten Kapazität verbindet.

Quarzoszillatoren werden in elektronischen Systemen zur Bereitstellung von System-internen Referenzfrequenzen und/oder Taktsignalen verwendet. Schwingquarze weisen eine Dämpfung auf, die sich in einem elektrischen Ersatzschaltbild als Ohm'scher Widerstand charakterisieren lässt, der mit einem Reihenschwingkreis aus einer Kapazität und einer Induktivität in Reihe liegt. Zur Erzeugung einer stabilen Schwingung muss der beim Schwingen elektrischer Ladung im Widerstand auftretende Energieverlust ersetzt werden.

Dies geschieht zum Beispiel durch die eingangs erwähnte Quarzoszillatorschaltung, wenn der Schwingquarz, gegebenenfalls noch ergänzt mit einer Lastkapazität, parallel zu dem kapazitiven Spannungsteiler der Schaltung angeschlossen ist. Eine solche Quarzoszillatorschaltung ist als Colpitts-Schaltung sowohl mit integrierten als auch mit externen Lastkapazitäten bekannt. Der Transkonduktanzverstärker kann ein einfacher Transistor in Kollektorschaltung sein, dessen Kollektor an ein positives Versorgungspotential, dessen Emitter als Verstärkerausgang an einen Mittelabgriff des Spannungsteilers, und dessen Basis als Verstärkereingang an einen komplementären Anschluss der ersten Kapazität angeschlossen ist. Der für die Colpitts-Schaltung charakteristische kapazitive Spannungsteiler bestimmt den Bruchteil einer über die so gebildete Schleife mitgekoppelten Spannung. Beim Colpitts Oszillator wird eine Spannung über einer der Kapazitäten gemessen und ein von der gemessenen Spannung abhängiger Strom in die andere Kapazität eingespeist. Dadurch ergeben sich Probleme bei einer Symmetrisierung der Schaltung, also bei einem symmetrischen Schaltungsaufbau, der auf Störsignale, die auf einem Masseanschluss auftreten, weniger empfindlich reagiert. Alle Ansätze, bei denen der Schwingquarz oder eine an den Schwingquarz angeschlossene Lastkapazität mit Masse verbunden ist, sind gegenüber Störsignalen auf dem Masseknoten empfindlich. Es ist daher bei integrierten Schaltungen, die neben einer (asymmetrischen) Quarzoszillatorschaltung noch weitere Schaltungsteile aufweisen, in der Regel erforderlich, einen separaten Masse-Pin für die Quarzoszillatorschaltung vorzusehen.

Vor diesem Hintergrund besteht die Aufgabe der Erfindung in der Angabe einer verbesserten Quarzoszillatorschaltung, die sich bedarfsweise symmetrisieren lässt.

Diese Aufgabe wird mit der Summe der Merkmale des Anspruch 1 gelöst. Von der Colpitts-Schaltung unterscheidet sich die erfindungsgemäße Schaltung dadurch, dass ein Eingang des Transkonduktanz-Verstärkers an einen Mittelabgriff zwischen der ersten und der zweiten Kapazität angeschlossen ist, ein Ausgang des Transkonduktanzverstärkers an einen komplementären Anschluss der ersten Kapazität angeschlossen ist, und die Quarzoszillatorschaltung ein an den Mittelabgriff parallel zu der zweiten Kapazität angeschlossenes leitfähiges Element aufweist. Bei der erfindungsgemäßen Schaltung wird eine Spannung gewissermaßen über der zweiten Kapazität gemessen und ein von der gemessenen Spannung abhängiger Strom in den Spannungsteiler eingespeist. Der damit verbundene Stromfluss durch die zweite Kapazität würde die Spannungsmessung verfälschen. Diese Verfälschung würde dazu führen, dass der negative Widerstand Re(z), der dem Schwingquarz angeboten wird, erheblich reduziert würde. Als Folge wäre ein sicheres, schnelles Anschwingen nicht gewährleistet. Das parallel zur zweiten Kapazität angeschlossene leitfähige Element kompensiert den Einfluss des genannten Stromflusses durch die zweite Kapazität auf die Spannungsmessung. Daher ergibt sich ein ähnlich großer negativer Widerstand Re(z) wie beim Colpitts-Oszillator, so dass ein schnelles und sicheres Anschwingen gewährleistet ist.

Dabei wird unter einem Transkonduktanz-Verstärker eine spannungsgesteuerte Stromquelle, also ein Verstärker verstanden, dessen Ausgangsstrom von seiner Eingangsspannung abhängig ist. Im einfachsten Fall kann ein solcher Transkonduktanz-Verstärker durch einen Transistor in Emitter-Schaltung (oder Source-Schaltung) realisiert werden, dessen Basis (oder Gate) mit dem Mittelabgriff verbunden ist, dessen Emitter (Source) über einen Widerstand an Masse, und dessen Kollektor (Drain) an eine Konstantstromquelle angeschlossen ist. Es können aber auch komplette OTA (Operational Transconductance Amplifier) verwendet werden.

Mit der Erfindung wird eine alternative Quarzoszillatorschaltung bereitgestellt, die sich durch einfache schaltungstechnische Maßnahmen symmetrisieren lässt und die nur zwei Anschluss-Pins benötigt (Signal und Masse bei der asymmetrischen Grundschaltung; ein differenzielles Signal bei der symmetrischen Ausgestaltung). Die asymmetrische Grundschaltung zeichnet sich durch einen besonders einfachen Aufbau aus, erlaubt den Anschluss einer externen Lastkapazität, und besitzt einen betragsmäßig großen negativen Widerstand, was zu einem schnellen und sicheren Anschwingen führt. Das schnelle und sichere Anschwingen ist dabei auch für die Fälle sicher gestellt, in denen ein neuer oder ein lange gelagerter Schwingquarz beim Anschwingen einen vergrößerten Widerstand aufweist (DLD-Effekt). Der DLD-Effekt kann dazu führen, dass bis zu 50-fach größere Widerstände als im normalen Betrieb auftreten.

Eine schaltungstechnisch besonders einfache, damit kostengünstige und platzsparende Ausgestaltung zeichnet sich dadurch aus, dass das leitfähige Element ein parallel zu der zweiten Kapazität geschalteter Ohm'scher Widerstand ist.

Alternativ ist bevorzugt, dass das leitfähige Element ein zweiter Transkonduktanzverstärker ist, der einen Eingang, einen Ausgang und eine den Eingang und den Ausgang verbindende Rückführung aufweist, wobei der Eingang und der Ausgang zwischen der ersten Kapazität und der zweiten Kapazität angeschlossen ist. Eingang und Ausgang sind ferner mit einem Eingang des ersten Transkonduktanzverstärkers verbunden.

Durch die Verbindung von Eingang und Ausgang wirkt der zweite Transkonduktanzverstärker wie ein Widerstand, so dass beide insofern austauschbar sind. Im Vergleich mit dem Widerstand liegt der Vorteil des zweiten Transkonduktanzverstärkers darin, dass er eine Regelung des Quotienten aus Strom und Spannung, also des zum Widerstand umgekehrt proportionalen Leitwerts, ermöglicht.

Eine weitere bevorzugte Ausgestaltung zeichnet sich dadurch aus, dass der kapazitive Spannungsteiler eine Reihenschaltung aus einer ersten Kapazität, einer zweiten Kapazität und einer dritten Kapazität aufweist.

Diese Ausgestaltung stellt eine symmetrische Variante der Quarzoszillatorschaltung dar. Im Vergleich mit der asymmetrischen Variante zeichnet sich die symmetrische Variante durch eine verringerte Empfindlichkeit gegenüber Störsignalen auf einer Masseleitung der Quarzoszillatorschaltung aus.

Die symmetrische Variante kann, wie auch die asymmetrische Variante, mit einem parallel zur zweiten Kapazität geschalteten Ohm'schen Widerstand als leitfähiges Element arbeiten. Alternativ ist das leitfähige Element ein zweiter Transkonduktanzverstärker, der einen differenziellen Eingang und einen differenziellen Ausgang aufweist, die beide parallel zur zweiten Kapazität geschaltet sind. Mit anderen Worten: ein Eingang ist zwischen der ersten und der zweiten Kapazität angeschlossen, ein weiterer Eingang ist zwischen der zweiten und der dritten Kapazität angeschlossen, und jeweils ein Ausgang ist mit einem Eingang des ersten Transkonduktanzverstärkers verbunden.

Bei diesen Ausgestaltungen der symmetrischen Variante stellen sich die gleichen Vorteile ein wie bei den entsprechenden Ausgestaltungen der asymmetrischen Variante, wobei bei der symmetrischen Variante wieder die verringerte Empfindlichkeit gegenüber Störsignalen auf einer Masseleitung der Quarzoszillatorschaltung dazu kommt.

Bevorzugt ist auch, dass eine Lastkapazität, die für den Betrieb eines Schwingquarzes notwendig sein kann, nicht in die Quarzoszillatorschaltung integriert ist, sondern als externe Kapazität angeschlossen wird. Dadurch wird Chip-Fläche der integrierten Quarzoszillatorschaltung gespart. Ein weiterer Vorteil ist, dass die zwischen Schwingquarz und Lastkapazität hin und her schwingende Ladung bei der externen Lastkapazität nicht in die integrierte Schaltung hineinfließt. Dies erleichtert einen ESD-Schutz der Quarzoszillatorschaltung (ESD = electrostatic discharge), weil auch Schutzschaltungen, die einen Serienwiderstand aufweisen, möglich sind.

Eine alternative Ausgestaltung zeichnet sich dagegen durch eine integrierte Lastkapazität aus. Dies hat den Vorteil, dass sich ein gewünschtes Verhältnis der Kapazitäten des kapazitiven Spannungteilers zur Lastkapazität bei der Herstellung der Schaltung besser einstellen lässt, was zu einem genauer definierten negativen Oszillatorwiderstand führt.

Eine weitere Ausgestaltung zeichnet sich durch wenigstens einen Spannungsfolger aus, der in einer Verbindung einer Anschlussklemme der Oszillatorschaltung mit dem kapazitiven Spannungsteiler angeordnet ist. Dadurch wird ein Stromfluss zwischen Schwingquarz und dem kapazitiven Spannungsteiler in der Oszillatorschaltung weiter verringert.

Bevorzugt ist ferner, dass der erste Transkonduktanzverstärker einen Transistor in Emitterschaltung aufweist. Alternativ oder ergänzend ist bevorzugt, dass wenigstens ein Transkonduktanzverstärker eine zwei Transistoren aufweisende Differenzstufe besitzt.

Diese Ausgestaltungen stellen konkrete schaltungstechnische Beispiele für Transkonduktanzverstärker dar.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Zeichnungen

Ausführungsbeispiele der Erfindung sind in den Zeichnungen dargestellt und werden in der nachfolgenden Beschreibung näher erläutert. Es zeigen, jeweils in schematischer Form:

Fig. 1    einen als Colpitts Oszillator bekannten Stand der Technik;

Fig. 2    eine erste asymmetrische Ausgestaltung eines erfindungsgemäßen Quarzoszillators mit einem Widerstand als leitfähiges Element;

Fig.3    eine Abwandlung des Quarzoszillators aus der Fig. 2 mit einem Transkonduktanzverstärker als leitfähiges Element;

Fig.4    eine symmetrische Ausgestaltung eines erfindungsgemäßen Quarzoszillators mit einem Widerstand als leitfähiges Element;

Fig. 5    eine symmetrische Ausgestaltung mit einem Transkonduktanzverstärker als leitfähiges Element; und

Fig. 6    eine symmetrische Ausgestaltung mit Differenzstufen aufweisenden Transkonduktanzverstärkern.

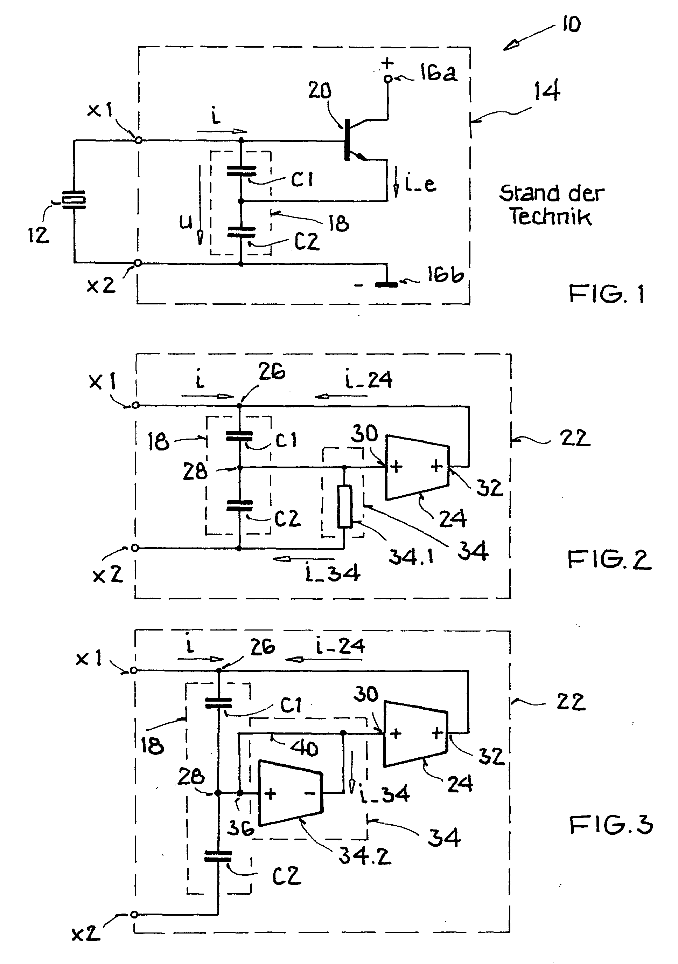

Im Einzelnen zeigt Fig. 1 einen als Colpitts-Oszillator bekannten Schwingkreis 10 aus einem Schwingquarz 12 und einer Quarzoszillatorschaltung 14 mit einer internen Energieversorgung 16a, 16b. Der Schwingquarz 12 ist an Klemmen X1, X2 der Oszillatorschaltung 14 angeschlossen. Die Oszillatorschaltung 14 weist einen kapazitiven Spannungsteiler 18 aus einer ersten Kapazität C1 und einer zweiten Kapazität C2 sowie einen Transkonduktanzverstärker in Form eines Transistors 20 in Kollektorschaltung auf, dessen Basis-Emitter-Strecke parallel zu der ersten Kapazität C1 liegt und dessen Transkonduktanz gm gleich der Ableitung seines Kollektorstroms nach seiner Basis-Emitter-Spannung ist.

Die Oszillatorschaltung 14 entdämpft den Schwingquarz bekanntlich dann, wenn ihr Widerstand negativ und betragsmäßig größer als der Dämpfungswiderstand des Schwingquarzes 12 ist. Für den Schwingquarz 12 stellt die Oszillatorschaltung 14 einen komplexen Widerstand

$$z = u / i$$

dar. Nur der Realteil Re(z) entscheidet darüber, ob die Schaltung schwingt oder nicht schwingt. Die Spannung u ist die Summe von Spannungen u1, u2 über den Kapazitäten C1, C2. Die Kapazität C2 wird durch den Strom i und den Emitterstrom $i\_e$ des Transistors 20 geladen und entladen. Für ihre Spannung u2 gilt also, dass

$$u2 = (i + i\_e) * z2$$

ist, wenn z2 den komplexen Widerstand von C2 darstellt. Der komplexe Widerstand z der Oszillatorschaltung 14 ergibt sich dann zu

$$z = (u1 + u2)/ i = z1 + z2 + (i\_e * z2)/i.$$

Einsetzen von $i\_e = i/j\omega C1 * gm$ und $z2 = 1/j\omega C2$ liefert dann den folgenden Realteil Re(z) von z:

$$\mathrm{Re}(z) = -\frac{gm}{\omega^2 C1 C2}$$

Heuristisch ausgedrückt misst der Transistor 20 die Spannung u1 über C1 und speist einen entdämpfenden, zu u1 proportionalen Emitterstrom $i\_e$ in den Mittelabgriff des kapazitiven Spannungsteilers 18 ein. Dieser Strom fließt nur durch C2, nicht durch C1.

Fig. 2 stellt eine erste asymmetrische Ausgestaltung einer erfindungsgemäßen Quarzoszillatorschaltung 22 dar. Dabei bezeichnen gleiche Ziffern in sämtlichen Figuren gleiche Elemente. Im Einzelnen zeigt Fig. 2 die Integrierte Quarzoszillatorschaltung 22 mit einem kapazitiven Spannungsteiler 18 aus der ersten Kapazität C1 und der zweiten Kapazität C2, einem ersten Transkonduktanzverstärker 24 in einer Schleife, die einen ersten Anschluss 26 und einen zweiten Anschluss 28 der ersten Kapazität C1 verbindet. Der zweite Anschluss 28 stellt einen Mittelabgriff des Spannungsteilers 18 dar. Ein Eingang 30 des Transkonduktanz-Verstärkers 24 ist an den Mittelabgriff 28 zwischen der ersten Kapazität C1 und der zweiten Kapazität C2 angeschlossen. Ein Ausgang 32 des Transkonduktanzverstärkers 24 ist an den komplementären ersten Anschluss 26 der ersten Kapazität C1 angeschlossen. Ferner weist die Quarzoszillatorschaltung 22 ein an den Mittelabgriff 28 angeschlossenes leitfähiges Element 34 auf. In der Ausgestaltung der Fig. 2 ist das leitfähige Element 34 ein parallel zu der zweiten Kapazität C2 geschalteter Ohm'scher Widerstand 34.1.

Die Wirkungen der strukturellen Unterschiede zwischen den Gegenständen der Fig. 1 und der Fig. 2 werden deutlich, wenn man die jeweils auf die Kapazitäten C1 und C2 wirkenden Ströme betrachtet. Im Fall der Fig. 1 wirkt auf C1 nur der Strom i, während auf C2 die Summe der Ströme i und $i\_e$ einwirkt. Im Fall der Fig. 2 wirkt auf die erste Kapazität C1 die Summe der Ströme i und i_24, wobei letzterer vom Transkonduktanzverstärker 24 als Funktion der Spannung an seinem Eingang 30 bereitgestellt wird. Der Strom i_24 vergrößert daher den auf C1 wirkenden Strom und realisiert damit eine Mitkopplung oder positive Rückkopplung. Das leitfähige Element 34 in Form des Widerstandes 34.1 lässt dagegen einen Stromfluss i_34 zu. Als Folge wirkt auf die zweite Kapazität C2 nicht die Summe aus i und i_24, sondern nur die Differenz aus der positiv zählenden Summe i und i_24 und des negativ zählenden Stroms i_34. Das leitfähige Element 34 realisiert damit eine Gegenkopplung oder negative Rückkopplung, stabilisiert somit den Arbeitspunkt der Oszillatorschaltung und vergrößert gleichzeitig den negativen Realteil Re(z) der Impedanz z der Oszillatorschaltung, so dass der Schwingquarz 12 schneller und sicherer anschwingt.

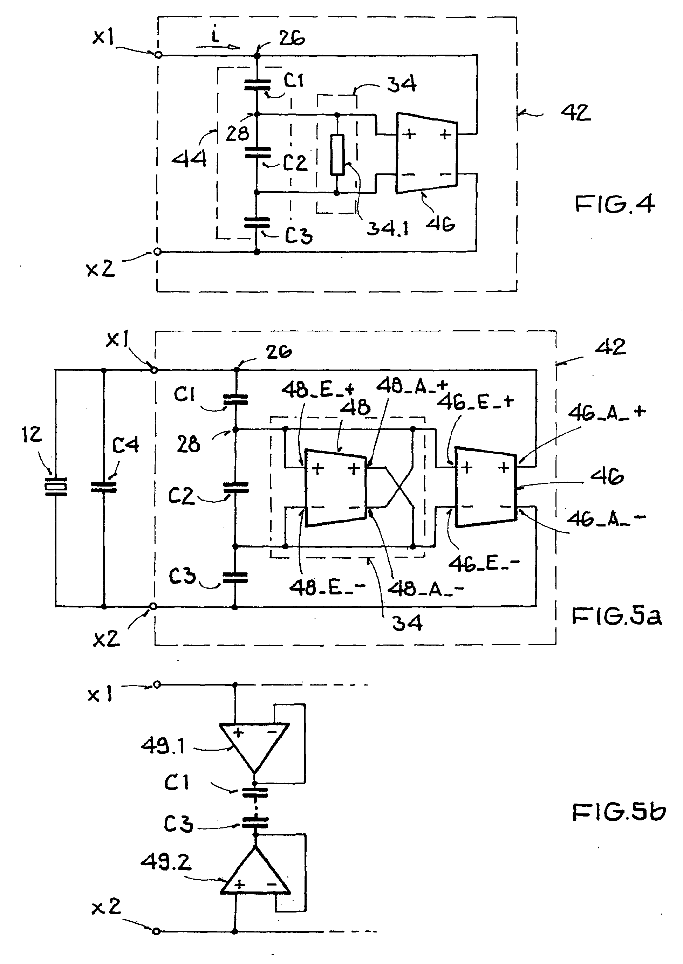

Fig. 3 zeigt eine Abwandlung der Quarzoszillatorschaltung 22 aus der Fig. 1 mit einem zweiten Transkonduktanzverstärker 34.2 als leitfähiges Element 34. Der zweite Transkonduktanzverstärker 34.2 weist einen Eingang 36, einen Ausgang 38 und eine den Eingang 36 und den Ausgang 38 verbindende Rückführung 40 auf, wobei der Eingang 36 und der Ausgang 38 jeweils an den Mittelabgriff 28 zwischen der ersten Kapazität C1 und der zweiten Kapazität C2 angeschlossen ist. Aufgrund der Rückführung 40 wirkt der zweite Transkonduktanzverstärker 34.2 wie der Widerstand 34.1 aus der Fig. 2. Bei festem Widerstandswert R sind Widerstand 34.1 und Transkonduktanzverstärker 34.2 daher austauschbar. Der Vorteil des Transkonduktanzverstärkers 34.2 besteht in einer Regelbarkeit, die zum Beispiel beim Einschalten eines mit einem DLD-Effekt behafteten Schwingquarzes eine Anpassung an den anfänglich hohen und dann abnehmenden Dämpfungswiderstand des Schwingquarzes erlaubt.

Fig.4 zeigt eine symmetrische Ausgestaltung einer weiteren erfindungsgemäßen Quarzoszillatorschaltung 42 mit einem kapazitiven Spannungsteiler 44 aus einer Reihenschaltung einer ersten Kapazität C1, einer zweiten Kapazität C2 und einer dritten Kapazität C3. Die dritte Kapazität C3 entspricht in ihrem Wert bevorzugt dem Wert der ersten Kapazität C1. Der zweiten Kapazität C2 ist das leitfähige Element 34 parallel geschaltet, das in der Fig. 4 wieder als Widerstand 34.1 realisiert ist. Die symmetrische Ausgestaltung weist ferner einen differenziellen ersten Transkonduktanzverstärker 46 auf. Diese symmetrische und differenzielle Version ist gegenüber Störsignalen auf der Masseleitung, also an der Klemme X2, wesentlich weniger empfindlich als die asymmetrische Version nach den Figuren 2 und 3.

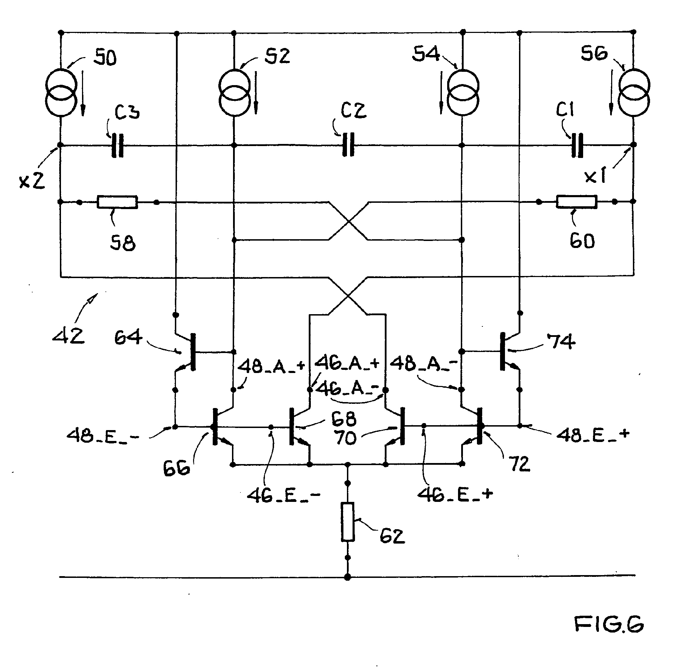

Fig. 5 a zeigt eine alternative Ausgestaltung der symmetrischen und differenziellen Variante 42, bei der das leitfähige Element 34 als zweiter differenzieller Transkonduktanzverstärker 48 realisiert ist. Außerdem weist der Gegenstand der Fig. 5 a noch eine externe Lastkapazität C4 auf, die bevorzugt auch bei den Gegenständen der Fig. 2 bis 4 vorhanden ist und die eine auf die Resonanzfrequenz des Schwingquarzes 12 abgestimmte Lastkapazität darstellt. Es ist auch möglich, die Lastkapazität C4 nicht extern, sondern innerhalb der integrierten Quarzoszillatorschaltung 42 (oder 22) vorzusehen, was ebenfalls für die Gegenstände der Figuren 2 bis 5 gilt. Fig. 5 b zeigt eine Ausgestaltung der Schaltung nach der Fig. 5 a, bei der zwischen den äußeren Kapazitäten C1, C3 des kapazitiven Spannungsteilers und den Klemmen X1, X2 je ein Spannungsfolger 49.1, 49.2 angeordnet ist. Der Vorteil dieser optional vorhandenen Spannungsfolger besteht darin, dass noch weniger Strom zwischen dem Quarz 12 und der Oszillatorschaltung 42 hin und her fließt. Dies ist aus den gleichen Gründen vorteilhaft, die bereits im Zusammenhang mit der externen Lastkapazität C4 genannt wurden. Ähnlich wie die Lastkapazität C4 können auch die Spannungsfolger 49.1, 49.2 auch bei dem Gegenständen der Figuren 2 bis 4 verwendet werden.

Allgemein gilt für die Transkonduktanzverstärker 46, und leitfähigen Elemente 34, 48 bei der differenziellen Variante, dass Ausgänge 46_A_+, 46_A_- des ersten Transkonduktanzverstärkers 46 an die Klemmen X1 und X2, also an die Lastkapazität C4 anzuschließen sind, während das leitfähige Element 34, 48 parallel zur zweiten Kapazität C2 anzuschließen ist. Bei Verwendung eines zweiten differenziellen Transkonduktanzverstärkers 48 als leitfähiges Element 34 sind die Eingänge 48_E_+, 48_E_- und Ausgänge 48_A_+, 48_A_- über Kreuz zu verbinden, damit der zweite Transkonduktanzverstärker 48 wie ein Widerstand wirkt. Da die Eingänge 46_E_+, 46_E_- des ersten Transkonduktanzverstärkers 46 und die Eingänge 48_E_+, 48_E_- des zweiten Transkonduktanzverstärkers 48 ebenfalls (über Kreuz) verbunden sind, kann die Anordnung der zwei Transkonduktanzverstärker 46, 48 auch durch einen einzigen Transkonduktanzverstärker realisiert werden, dessen Ausgangsstrom über eine Stromspiegelanordnung mit vorbestimmtem Stromübersetzungsverhältnis zweimal mit verschiedener Stromstärke bereit gestellt wird. Dabei wird unter einer "über Kreuz"-Verbindung eine Verbindung von "..._+" nach "..._-" und umgekehrt, also eine negative Rückkopplung, verstanden.

Zur Arbeitspunkteinstellung kann zwischen den Anschluss X1 und den Ausgang 48_A_+ sowie zwischen dem Anschluss X2 und dem Ausgang 48_A_- je ein Widerstand $R_b$ angeordnet sein. Für den Fall, dass der Wert von C 1 gleich dem Wert von C3 gleich einem Wert 2C ist, gilt für die Eingangsimpedanz der Oszillatorschaltung 42 einschließlich der Lastkapazität C4:

$$z = \frac{R_b^{-1} + g_{m2} + j\omega(C + C2)}{(g_{m1} + g_{m2})R_b^{-1} - \omega^2(C4C + C4C2 + CC2) + j\omega((C4 + C)g_{m2} - Cg_{m1} + (C4 + C2)R_b^{-1})}$$

Unter Vernachlässigung der Widerstände vereinfacht sich dies zu:

$$z = \frac{g_{m2} + j\omega(C+C2)}{-\omega^2(C4C + C4C2 + CC2) + j\omega((C4+C)g_{m2} - Cg_{m1})}$$

Und für den Spezialfall

$$(C4+C)g_{m2} = C\,g_{m1}$$

ergibt sich ferner:

$$z = \frac{1}{j\omega\left(C4 + \left(C^{-1} + C2^{-1}\right)^{-1}\right)} - \frac{g_{m2}}{\omega^2(C4C + C4C2 + CC2)}$$

Fig.6 zeigt eine symmetrische Ausgestaltung einer Quarzoszillatorschaltung 42 mit Differenzstufen aufweisenden Transkonduktanzverstärkern 46, 48 als konkrete schaltungstechnische Ausgestaltung des Gegenstands der Fig. 5. Die Quarzoszillatorschaltung 42 weist neben den drei Kapazitäten C1, C2 und C3 vier Stromquellen 50, 52, 54 und 56, drei Widerstände 58, 60 und 62 sowie sechs Transistoren 64, 66, 68, 70, 72 und 74 auf. Die Widerstände 58 und 60 dienen dazu, den Arbeitspunkt an den Klemmen X1 und X2 festzulegen. Die Transistoren 68 und 70 bilden zusammen eine Differenzstufe des ersten Transkonduktanzverstärkers 46. Analog bilden die Transistoren 66 und 72 eine Differenzstufe des zweiten Transkonduktanzverstärkers 48. Bei einem Verhältnis der Werte der Transkonduktanzen gm1 des ersten Transkonduktanzverstärkers 46 und gm2 des zweiten Transkonduktanzverstärkers 48 stellen die Stromquellen 52 und 54 ein Zehnfaches der Stromstärke der Stromquellen 50 und 56 bereit. Entsprechend wird über die Transistoren 68 und 70 ein Zehnfaches der Stromstärke gesteuert, die über die Transistoren 66 und 72 gesteuert wird. Die Transistoren 64 und 74 stellen lediglich Emitterfolger dar.

Für die Integration lässt sich sowohl eine reine Bipolar-Technologie, eine reine CMOS-Technologie oder auch eine sowohl bipolare als auch CMOS-Bauelemente aufweisende BiCMOS-Technologie verwenden. Bei der Verwendung von CMOS-Bauelementen werden zum Beispiel die genannten Emitterschaltungen durch Sourceschaltungen ersetzt. Vorteile der Bipolartechnologie liegen in einer großen Transkonduktanz und damit einem großen Re(z) bereits bei relativ kleinen Kollektorströmen. Vorteile der CMOS-Technologie liegen darin, dass sich die Oszillatorschaltung zusammen mit digitalen, beziehungsweise gemischt digitalen und analogen Schaltungen, für die bevorzugt CMOS-Technologien verwendet werden, auf einem Chip integrieren lässt. Die BiCMOS-Technologie vereinigt sämtliche dieser Vorteile.

**Patentansprüche**

1. Integrierte Quarzoszillatorschaltung (22; 42) mit einem kapazitiven Spannungsteiler (18), der eine erste Kapazität (C1) und eine zweite Kapazität (C2) aufweist, sowie mit einem ersten Transkonduktanzverstärker (24; 46), der in einer Schleife angeordnet ist, die einen ersten Anschluss (26) und einen zweiten Anschluss (28) der ersten Kapazität (C1) verbindet, **dadurch gekennzeichnet, dass** ein Eingang (30; 46_E_+) des ersten Transkonduktanzverstärkers (24; 46) an einen Mittelabgriff zwischen der ersten Kapazität (C1) und der zweiten Kapazität (C2) angeschlossen ist, ein Ausgang (32; 46_A+) des ersten Transkonduktanzverstärkers (24; 46) an den ersten Anschluss (26) der ersten Kapazität (C1) angeschlossen ist, und die Quarzoszillatorschaltung (22; 42) ein parallel zu der zweiten Kapazität (C2) angeschlossenes leitfähiges Element (34; 48) aufweist.

2. Quarzoszillatorschaltung (22; 44) nach Anspruch 1, **dadurch gekennzeichnet, dass** das leitfähige Element (34) ein parallel zu der zweiten Kapazität (C2) geschalteter Ohm'scher Widerstand (34.1) ist.

3. Quarzoszillatorschaltung (22) nach Anspruch 1, **dadurch gekennzeichnet, dass** das leitfähige Element (34) ein zweiter Transkonduktanzverstärker (34.2) ist, der einen Eingang (36), einen Ausgang (38) und eine den Eingang (36) und den Ausgang (38) verbindende Rückführung (40) aufweist, wobei der Eingang (36) und der Ausgang (38) zwischen der ersten Kapazität (C1) und der zweiten Kapazität (C2) angeschlossen ist.

4. Quarzoszillatorschaltung (42) nach Anspruch 1, **dadurch gekennzeichnet, dass** der kapazitive Spannungsteiler (44) eine Reihenschaltung aus einer ersten Kapazität (C1), einer zweiten Kapazität (C2) und einer dritten Kapazität (C3) aufweist.

5. Quarzoszillatorschaltung (42) nach Anspruch 4, **dadurch gekennzeichnet, dass** das leitfähige Element (34) ein parallel zu der zweiten Kapazität (C2) geschalteter Ohm'scher Widerstand (34.1) ist.

6. Quarzoszillatorschaltung (42) nach Anspruch 4, **dadurch gekennzeichnet, dass** das leitfähige Element (34) ein zweiter Transkonduktanzverstärker (48) ist, der zwei Eingänge (48_E_+, 48_E_-), zwei Ausgänge (48_A_+, 48_A_-), und jeweils einen Eingang (48_E_+, 48_E_-) und einen Ausgang (48_A_-, 48_A_+) verbindende Rückführungen aufweist, wobei ein Eingang (48_E_+) zwischen der ersten (C1) und der zweiten Kapazität (C2) angeschlossen ist, ein weiterer Eingang (48_E_-) zwischen der zweiten (C2) und der dritten Kapazität (C3) angeschlossen ist, und jeweils ein Ausgang (48_A_-, 48_A_+) mit einem Eingang (46_E_+, 46_E_-), des ersten Transkonduktanzverstärkers (46) verbunden ist.

7. Quarzoszillator (22; 42) nach einem der vorhergehenden Ansprüche, **gekennzeichnet durch** eine schaltungsexterne Lastkapazität (C4).

8. Quarzoszillator nach einem der vorhergehenden Ansprüche, **gekennzeichnet durch** eine integrierte Lastkapazität (C4).

9. Quarzoszillator nach einem der vorhergehenden Ansprüche, **gekennzeichnet durch** wenigstens einen Spannungsfolger (49.1, 49.2), der in einer Verbindung einer Anschlussklemme (X1, X2) der Oszillatorschaltung (22; 42) mit dem kapazitiven Spannungsteiler angeordnet ist.

10. Quarzoszillator nach einem der vorhergehenden Ansprüche, **dadurch gekennzeichnet, dass** der erste Transkonduktanzverstärker einen Transistor in Emitterschaltung aufweist.

11. Quarzoszillator nach einem der vorhergehenden Ansprüche, **dadurch gekennzeichnet, dass** wenigstens ein Transkonduktanzverstärker eine zwei Transistoren aufweisende Differenzstufe besitzt.

FIG. 1

Stand der Technik

FIG. 2

FIG. 3

FIG.4

FIG.5a

FIG.5b

FIG.6